Europäisches Patentamt

European Patent Office

Office européen des brevets

(11) Publication number: **0 482 685 A2**

# EUROPEAN PATENT APPLICATION

(21) Application number: **91202484.1**

(51) Int. Cl.5: **H05K 7/18**

(22) Date of filing: **25.09.91**

(30) Priority: **26.10.90 IT 2202390 U**

(43) Date of publication of application:
**29.04.92 Bulletin 92/18**

(84) Designated Contracting States:
**AT BE CH DE DK ES FR GB GR IT LI LU NL SE**

(71) Applicant: **TURATI LUIGI S.p.A.**
**Corso Martiri, 31**
**I-22053 Lecco (Como)(IT)**

(72) Inventor: **Turati, Luigi**
**Via Rimembranze, 10**
**I-22040 Sirone (Como)(IT)**

(74) Representative: **De Carli, Erberto et al**
**ING. BARZANO' & ZANARDO MILANO S.p.A.**
**Via Borgonuovo, 10**
**I-20121 Milano(IT)**

(54) **Sealed cubicle, in particular for electrical equipment.**

(57) The cubicle (1) is of the type for housing electrical and electronic equipment and is therefore sealed. Structural simplification is achieved by forming the frame from structural shapes (2, 2A) of open cross-section. The lateral ends (6, 6A) of the structural shape are mutually perpendicular and penetrate into the gaskets (4) positioned on the perpendicular walls (3, 3A) fixed to said frame.

Fig.2

This invention relates to a sealed cubicle, in particular for electrical and electronic equipment.

Known cubicles of this type comprise substantially a frame formed from a plurality of connected section bars on which at least the outer walls are mounted by way of gaskets for sealing the cubicle. Although these cubicles totally satisfy their requirements they involve an amount of work (in constructing their component parts and in assembling them) which for reasons of commercial competitiveness it would be advantageous to reduce, but without the consequent cost reduction resulting in an undermining of product quality or in a cubicle which does not satisfy safety regulations.

To achieve this, several tendentially contrasting requirements (constructional, assembly and cost) must be satisfied simultaneously.

The object of the present invention is therefore to satisfy these requirements.

This object is attained by a cubicle in accordance with the introductory part of claim 1, characterised in that the section bars which form the frame are obtained from a structural shape having a cross-section of open configuration, their lateral ends engaging the seal gaskets.

The fact that the cross-section of the structural shape is of open configuration substantially simplifies its production, leading to further evident technical and cost advantages.

The fact that the lateral ends of the section bars engage the gaskets simplifies the formation of the seal points on the cubicle and its assembly.

The invention is illustrated by way of non-limiting example in the figures of the accompanying drawings.

Figure 1 is a perspective view of a cubicle according to the invention shown with a single door in the open position and without its outer walls, but provided with an inner panel for carrying electrical equipment;

Figure 2 is a section on the line II-II of Figure 1 with the outer walls present, the door being shown in the closed position and the inner panel removed;

Figure 3 is a section on the line III-III of Figure 2;

Figure 4 is a section on the line IV-IV of Figure 2;

Figure 5 is a perspective schematic view of that corner of the frame indicated by V in Figure 1.

With reference to the aforesaid figures the sealed cubicle 1 for electrical equipment is preferably constructed of coated metal, but can be of stainless steel, plastics or other materials.

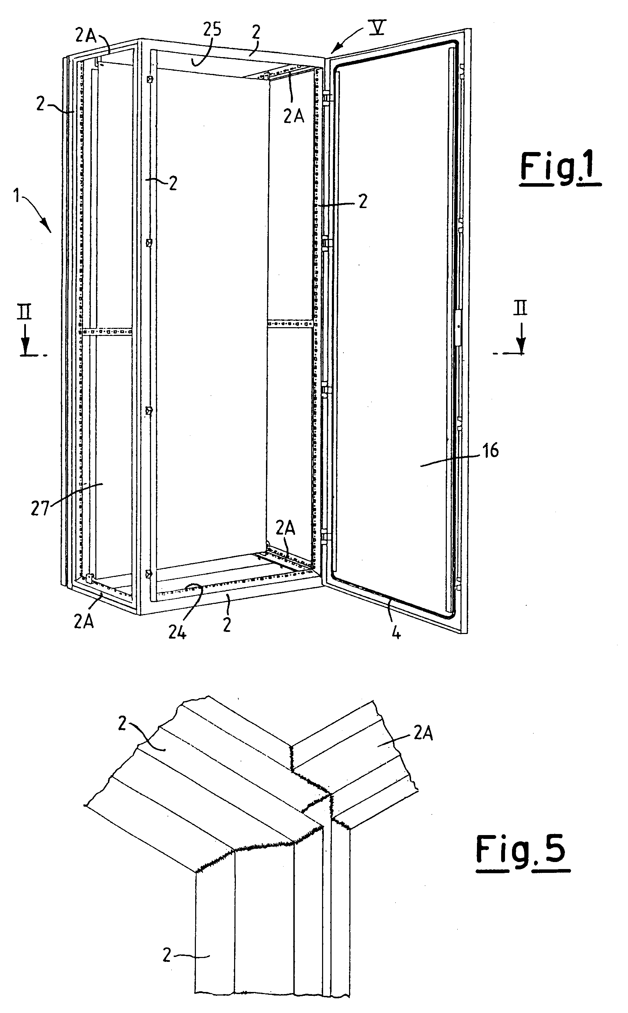

In its most basic form it comprises a frame to which outer walls 3, 3A, a base 24, a top 25 and possibly inner panels are connected, one of these latter being shown in Figure 1, in which it is indicated by 27.

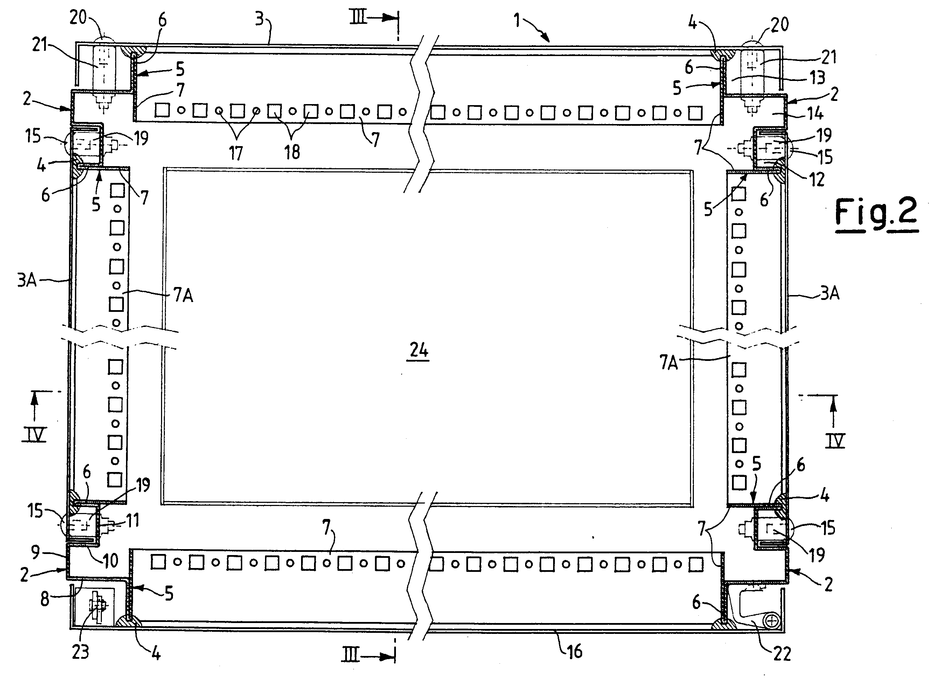

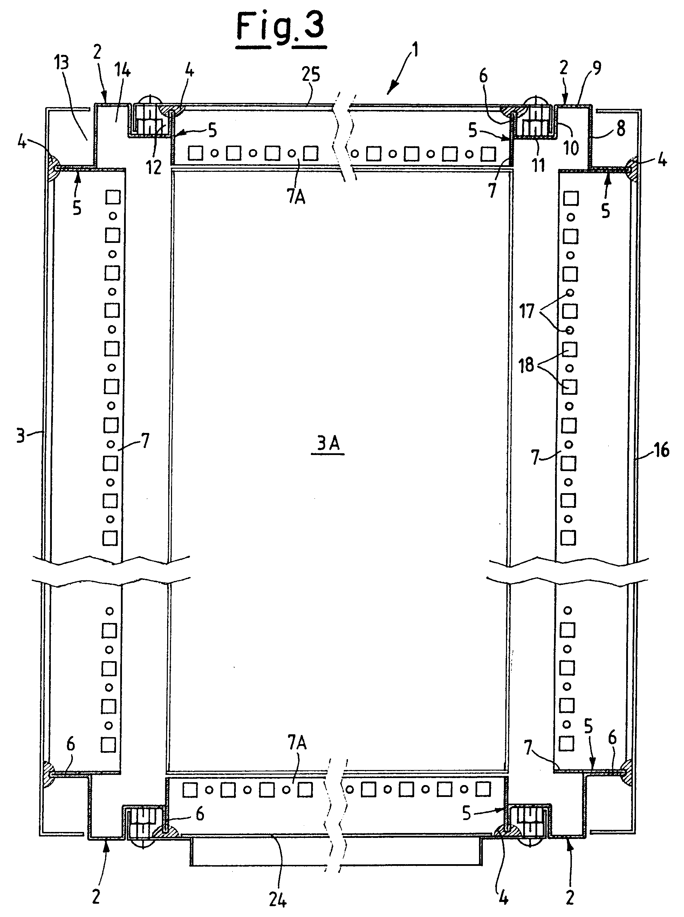

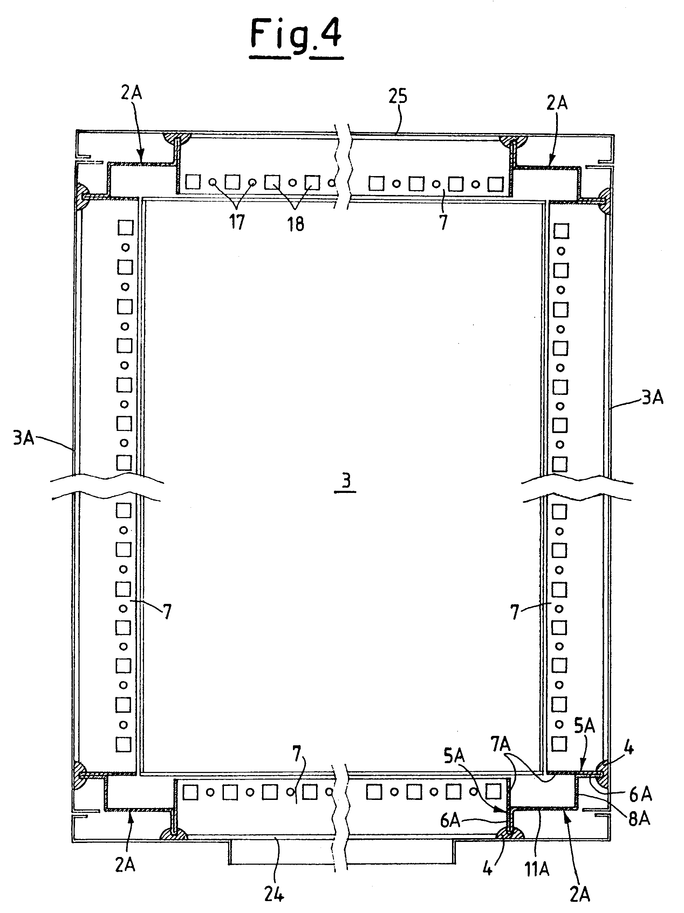

In its most basic form the frame is formed from four uprights and four cross-members, connected together by four depth members. The four uprights and the four cross-members are obtained by cutting a single structural shape 2 into bars of suitable length (see Figures 2 and 3) while the depth members are obtained by cutting a structural shape 2A into bars of suitable length (see Figure 4).

The uprights, the cross-members and the depth members are joined together along a plane at 45° to the major axis of the depth member, preferably by welding.

The outer walls 3 and 3A are of different sizes but have the same U cross-section. The base 24 and the top 25 consist of sheet portions preferably welded to the frame.

The structural shapes 2 and 2A have an open configuration and consist of two end flanges 5, 5A joined together by an intermediate portion formed from a plurality of connection regions 8, 9, 10, 11 and 8A, 11A.

The flanges 5, 5A lie in converging planes, which are preferably perpendicular. The fact that the flanges 5, 5A converge enables a simultaneous seal to be formed between two meeting parts, which in this particular case are also mutually perpendicular as the cubicle of the illustrated example is of rectangular plan.

Each flange 5, 5A comprises an end 6, 6A facing outwards from the cubicle 1 and a portion 7, 7A facing inwards.

The ends 6, 6A are preferably formed by folding onto itself a portion of the metal strip from which the entire structural shape 2, 2A is formed.

The ends 6, 6A each penetrate into a gasket 4 of U cross-section, preferably constructed of soft yieldable material which perfectly adheres to the outer surfaces of said end.

It should be noted that as at least one end 6, 6A or portion thereof penetrates into the gasket 4 a very effective seal is obtained, particularly against moisture. This is because the seal is obtained along several incident planes (preferably mutually perpendicular). In addition the fact that those ends 5, 5A which penetrate into the gasket are obtained by folding onto itself the metal strip which forms the structural shapes 2, 2A means that a sealing surface of curved configuration interposed between the remainder is easily and economically obtained.

The curved configuration tends to eliminate sharp edges at the connection points with the adjacent surfaces, so providing an improved seal.

Those portions 7 and 7A facing the interior of the cubicle 1 carry holes for fixing the contents of the cubicle 1. In the case shown, the holes are alternately circular 17 and square 18 and are particularly suitable for fixing electrical equipment or its relative supports. This makes a large number of positions available for fixing the electrical equipment and/or relative supports or panels 27 without it being necessary to use additional pieces which could result in the need for adaptation either during the assembly of the cubicle or on changing the position of previously installed equipment.

The connection regions 8-11 and 8A, 11A forming the intermediate portion of the structural shapes 2 and 2A lie preferably at an angle of 90° to each other.

In the case of the structural shape 2 (see Figures 2 and 3), these connection regions comprise a first indicated by 8, a second indicated by 9, a third indicated by 10 and a fourth indicated by 11.

The converging arrangement of the connection regions results in the formation of housings for engagement by the fixing elements of the outer walls 3 and 3A. The specifically perpendicular arrangement results in a rational housing shape, making these housings easily accessible to tools (spanners) used for assembling the cubicle.

In the illustrated example one of the housings is in the form of a socket 12 with its cavity facing outwards from the cubicle 1 and is formed by the end 6, the fourth connection region 11 and the third connection region 10. A first bolt 15 passes through the socket 12 via a spacer 19 for fixing the outer wall 3A.

A further housing is in the form of a seat 13 formed by the end 6 of the remaining flange 5 and the first connection region 8. The seat 13 accommodates a second bolt 20 and spacer 21. The first connection region 8, the second 9 and the third 10 together define a socket 14 with its cavity facing the interior of the cubicle and housing the nut of the second bolt 20, which can hence be easily manipulated by a spanner, which gains access by at least partly occupying the volume of said socket 14.

The outer, largest walls 3 can be converted into a door 16 by simply replacing the bolts 20 with a hinge 22 and a catch 23, forming the door locking means. No modification to the prechosen shape of the wall 3 is necessary. The hinge 22 and catch 23 are housed in the seats 13 of two section bars. It is therefore apparent that a cubicle could also be provided with two opposite doors to satisfy special requirements.

The outer walls 3 and 3A and hence also the door 16 are of U cross-section, the outer portions of which close the sockets 12 and the seats 13.

The outer walls 3A are smaller than the side of the cubicle which they are each required to close, but this is compensated by the fact that the second connection region 9 and a bent flange of the wall 3 represent portions of said side of the cubicle.

However, in the case of the structural shape 2A (see Figure 4), there are only two connection regions, the first being indicated by 8A and the second by 11A. The structure and mutual arrangement of the flanges 5A are as already described. The connection regions meet preferably perpendicularly.

## Claims

1. A sealed cubicle (1), in particular for housing electrical and electronic equipment, comprising a frame formed from a plurality of connected section bars on which at least the outer walls (3, 3A) are mounted by way of gaskets (4) for sealing the cubicle, characterised in that said section bars are obtained from a structural shape (2, 2A) having a cross-section of open configuration, their lateral ends (6, 6A) engaging the seal gaskets (4).

2. A cubicle as claimed in claim 1, characterised in that the structural shape (2, 2A) comprises flanges (5, 5A) lying in convergent planes, said flanges (5, 5A) penetrating by at least one end (6, 6A) or a portion thereof into the seal gaskets (4).

3. A cubicle as claimed in claim 2, characterised in that the flanges (5, 5A) lie in mutually perpendicular planes.

4. A cubicle as claimed in claim 2, characterised in that the flanges (5, 5A) are joined together by at least two connection regions (8A, 11A), said regions being mutually incident.

5. A cubicle as claimed in claim 4, characterised in that the flanges (5) are joined together by connection regions (8-11) which lie alternately perpendicular to form housings (12-14) engagable by fixing elements (15, 19-21) for the outer walls which close the cubicle.

6. A cubicle as claimed in claim 2, characterised in that those ends (6, 6A) of the flanges which penetrate into the gasket (4) are obtained by folding onto itself the strip which forms the structural shape (2, 2A).

7. A cubicle as claimed in claim 2, characterised in that the flanges (5, 5A) comprise a portion (7, 7A) extending into the cubicle (1) and comprising fixing holes (17, 18).

8. A cubicle as claimed in claim 5, characterised in that the housings include a socket (12) with its cavity facing outwards from the cubicle, a socket (14) with its cavity facing the interior of the cubicle, and an L-shaped seat (13) facing outwards from the cubicle (1).

9. A cubicle as claimed in claim 8, characterised in that the L-shaped seats of two adjacent section bars can house the hinges (22) and locking means (23) for the cubicle (1) respectively.

10. A cubicle as claimed in claim 5, characterised in that the fixing elements comprise bolts (15, 20) provided with spacers (19, 21).

11. A cubicle as claimed in claim 5, characterised in that the outer walls (3, 3A) of the cubicle (1) are of U cross-section, their outer edges closing the socket (12) with its outwardly facing cavity and the L-shaped seat (13).

12. A cubicle as claimed in claim 1, characterised in that the uprights, the cross-members and the depth members are joined together on a plane at 45° to their major axis, the joints preferably being obtained by welding.

13. A cubicle as claimed in claim 1, characterised in that the seal gaskets (4) are of U cross-section and elastically adhere to those ends (6) of the flanges (5) which penetrate into them.

# Fig.1

# Fig.5

**Fig.2**

EP 0 482 685 A2

# Fig.3

# Fig.4